# NEW EUROPEAN PATENT SPECIFICATION

(11) **EP 0 486 989 B2**
(45) Date of publication and mention of the opposition decision: **08.08.2007**
(45) Mention of the grant of the patent: 04.02.1998
(21) Application number: 91119634.3
(22) Date of filing: 18.11.1991
(51) Int. Cl.: H04N 5/45

(54) **Device to perfect the selecting of television signals**
Verfahren zum Auswählen von Fernsehersignalen
Dispositif de sélectionnement de signaux de télévision

(30) Priority: 22.11.1990 IT 6791290
(43) Date of publication of application: 27.05.1992
(60) Divisional application: 96115364.0
(73) Proprietor: EDICO S.r.l., 00196 Roma (IT)
(72) Inventor: Dini, Roberto, I-10095 Rivoli (TO) (IT); Farina, Attilio, I-10127 Torino (TO) (IT)
(74) Representative: Eisenführ, Speiser & Partner

(56) References cited:
- EP-A- 0 068 422
- EP-A- 0 360 070
- EP-A- 0 391 656
- WO-A1-88/04507
- DE-C2- 3 031 527
- PATENT ABSTRACT OF JAPAN vol. 11, no. 387 (E-566) 17 December 1987 & JP-A-62 152 276
- PATENT ABSTRACT OF JAPAN vol. 14, no. 584 (E-101) 27 December 1989 & JP-A-2 254 894
- Operating Instructions of Grundig Videorecorder VS 540 and remote control RP 6
- PATENT ABSTRACT OF JAPAN vol. 8, no. 272 (E-284)(1709) 13 December 1984 & JP-A-59 141 816
- User's manual of television sets MALLORCA VT 7994 and TAHITI 70-100 VT 7999 of Metz.
- Zeisel G. et al: "An Interactive menu-driven Remote Control Unit for TV-Receivers and VC-Recorders", IEEE Transactions in Consumer Electronics, Vol. 34, No. 3, August 1988
- Patent abstract of Japan, JP-A-01268368, 26.10.1989

## Description

The present invention relates to a device for the selection of television signals, comprising means for the tuning of television signals, memory means for memorising the information for the relative tuning of preferred signals, and an image display means with the possibility to visualize information for the selection of said preferred signals.

There are known television receivers in the prior art that have the characteristics described above.

For example, the Italian patent application No. 68491-A/78, is a television receiver that can visualize on the screen a so called 'memory map', i.e., a chart on which appears the numbers of the memorised channels. As known, according to the European television system; every channel reserved to the television emissions has a number, for example in the range VHF the numbers are assigned from 2 to 12 and in the range UHF the numbers range from 21 to 69.

Such numbers however are not, in the greater part of the cases, known by the user, therefore a memory map of the type indicated is very seldom useful or practical.

Furthermore, it is known from EP-A-0 267 020 a device according to the preamble of claim 1.

Finally, from the Operating Instructions of Grundig Videorecorder VS 540 is known a video recorder that for programming the recording means makes use of a program table associated with a teletext page.

The present invention takes into consideration this fact and has the aim of indicating a system more effective than those known, in facilitating the selection of the program desired on behalf of a normal user, who is not a technician.

For achieving such aims the present invention provides a device as defined in claim 1.

Further aims and advantages will become clear from the present description and annexed drawings, supplied as an explicative and non limiting example, wherein:
Figure 1 represents a block diagram of a part of circuit of a television receiver according to the invention;
Figure 2 represent the screen of a television receiver according to the invention;
Figure 3 represents a command device of the apparatus in figure 1;
Figure 4 represents a block diagram of a part of the logic control circuit of the apparatus of figure 1.

So as to provide for a simple understanding of the following description, the term "icon " has been used for the graphic symbols that represent the logotype normally used by a broadcasting station to identify itself.

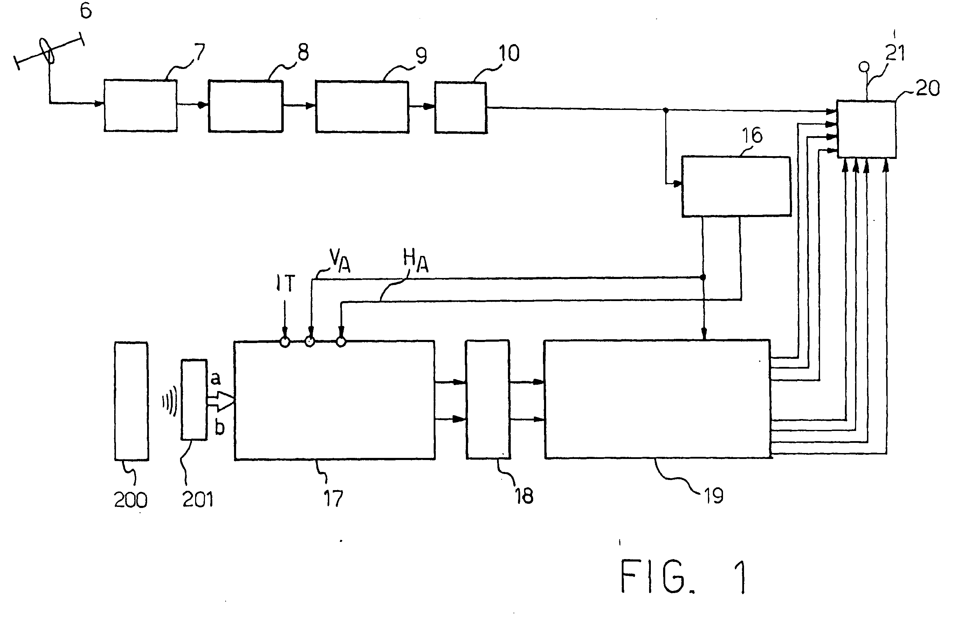

In figure 1 a block diagram represents part of the circuit of a television receiver according to the invention.

In figure 1 the reference number 6 represents a receiving antenna ; reference number 7 indicates a tuner, of the type known, that serves to tune the television signal.

Reference number 8 represents an amplifier of intermediate frequency; number 9 indicates the video detector and number 10 a pre-amplifier of a video signal.

Reference number 16 indicates a circuit that generates the vertical and horizontal synchronism signals starting from the suitable impulses contained in the video.

Reference number 200 indicates a remote control unit, for example of the usual infrared type; number 201 indicates the respective signal receiver; that is coupled to a control circuit, indicated with the reference number 17, which will be mentioned later, circuit 17 can also receive vertical and horizontal synchronism signals (VA, HA).

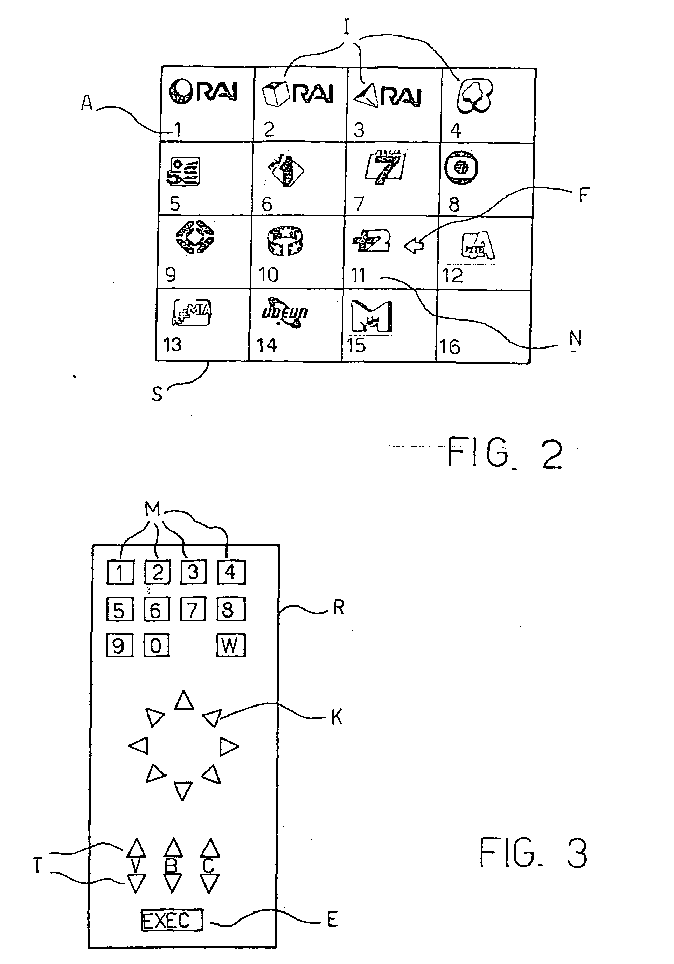

Reference number 18 indicates the clock impulse generator; 19 indicates a memory, preferably to be read and written, but in any case of the non-volatile type; such a memory serves to memorise the icons so as to carry out the image represented in figure 2.

The majority of such icons will have already been memorised in memory 19 in the place of manufacture or installation; it is however convenient to provide a special entrance for the introduction of new icons on the part of the user, when new broadcasting stations are activated, or stations already in existence changing their icon.

Such an entrance can be provided in the control circuit 17 and is indicated with the symbol IT; the use of special magnetic cards or a bar code reader, or other suitable systems can be used for the introduction of the icons.

An alternating system, that would have the advantage of consenting an easy replacement or addition of icons, is that said icons are transmitted directly by the broadcasting station concerned, by a special teletext page; at this point the circuit 17 can be pre-arranged in order to be able to read it along with the televideo signal and to register it in a memory 19, according to the users command, or even automatically.

Naturally, it is necessary that the icon is always transmitted by the broadcasting station on a determined televideo page previously known (for example the page 799) and that the receiver is endowed with a teletext decoder; the control circuit is pre-arranged to command the decoder to read page 799, and to memorise the icon in memory 19, in the cell with the corresponding number in the tuned program (see the following information that is given in the description of the Figures 2 and 3).

In the case in which the reading and memorising of the icon are both foreseen to be controlled by the user, a special key will be provided on the remote control unit 200 or on the control panel of the receiver; in the case of automatic acquisition, circuit 17 will be prepared to obtain it at any time that the tuning of a certain program is made.

Reference number 20 indicates a commutation circuit which receives the video signal and the signals received from memory 19 ; reference number 21 indicates an output terminal with which the video signal is available containing the received television image or the image built with the assistance of the memorised icons in memory 19.

Figure 2 represents the aspect of the screen of a television receiver according to said invention; said screen is represented divided into 16 parts, but the parts could also be of a different number, greater or smaller and this would not be a determining factor.

Each part corresponds to the corresponding program received and the co-ordinates for tuning are memorised and married with a numbered key; the number of such key, i.e. the number assigned to the corresponding program, is shown in the lower left hand corner of every single part of the image (note for example reference symbols A and N).

In each division a icon is represented (1), corresponding to the "logo" of the corresponding broadcasting station; for example the three RAI networks are represented by the blue sphere, red cube and a green tetrahedron;Canale 5, the characteristic snake, and so on.

Reference symbol F represents a cursor element in the upper right hand corner of the image N° 11, with the form of an arrow (but could also be of any other form), obtained, also here by means of the prior art, superimposed on the image, or, better said, on the images, as is so for the numbers A.

Such cursor element can be made more visible by making it flash, which can be done also by the use of the prior art, for example eliminating it for 5 fields and making it visible for the following 5 fields.

At this point, the number of the program could also be simply used as a marking element (A), made to flash, without having the necessity of introducing the additional element F.

In the case in which the broadcasting stations to be memorised are of a greater number than 16, or the maximum number which may be conveniently displayed by means of the icons on the screen, the icons, for example 32, can be shown by means of two successive displays; the "+" and "-" keys that are normally provided for on every remote control unit panels can be used to pass from one display to the next, in either sense.

The utilisation of the "+" and "-" keys in such a way is enabled by previously depressing key W.

Figure 3 represents a control device for the apparatus of which the screen is designed in figure 1; such device can be the transmitter of a normal infrared ray remote control unit.

In figure 3 the reference symbol R represents the remote control transmitter; the symbol M indicates a plurality of numbered keys of known functions and that obviously serve for the control of the normal functions of the apparatus; symbol T represents other usual keys, as those for the control of the volume (V), brightness (B) and colour (C).

The symbol W indicates a key that serves to show the image represented in figure 2 (icon map).

Reference symbol K indicates 8 keys that have the form of isosceles triangles, with the more pointed vertexes of which being directed externally, disposed according to the vertexes of an octagon.

Such keys serve for the moving of the cursor element F from a given icon to a contiguous one; in the case in which element F is, as indicated in figure 1, in the icon number 11, it can be moved, by means of one of the 8 keys K, in one of the 8 contiguous images (6,7,8,10,12,14,15,16), for example by depressing the key with its point at the top, the marker moves into image N° 7; pressing the key in the upper left hand corner, the marker then moves into image N° 6, and so on, in an intuitive manner. In such a way that it is easy for anybody to move the marker; by using, at the most, three movements any image can be reached starting from any point on the screen.

Once the marker has been placed in the chosen icon, it is sufficient to depress the key indicated by the symbol E (EXEC key) and the relative program will be displayed on the full screen.

This is obtained as the character generator, that generates the numbers A and eventually the marker F (in the case that the same number is not being used as a marker, made flashing), knows the co-ordinate (line and column) of the same marker, and therefore in which box of the diagram it is to be found Therefore it is sufficient to refer to the line numbers and column relative to the marker and to the number of the box, and therefore of the relative image and to give the receiver the command to select the correspondent program with such number (in practice the tuning data will be memorised in one of the correspondent boxes of the tuner's memory). Instead of the eight keys K, if preferred, only one key could be used, for example having the form of an octagon or a round disc horizontally positioned and making the relative contacts function according to the way in which it is depressed. On the key, for example that of a disk form, 8 arrows could be printed to indicate the direction in which it must be depressed.

One notes that to pass from a device with 4 keys to one with eight keys, i.e. to obtain also a diagonal movement that in the described case saves three movements in the case of passing from one angle of the image to the opposite angle, other contacts are not needed.

In fact, is sufficient that the 4 angle keys close both the contacts of the two adjacent keys.

In the case of a greater number of programs, the advantage of the diagonal keys is still greater: in such a case, in fact, we can save a greater number of movements.

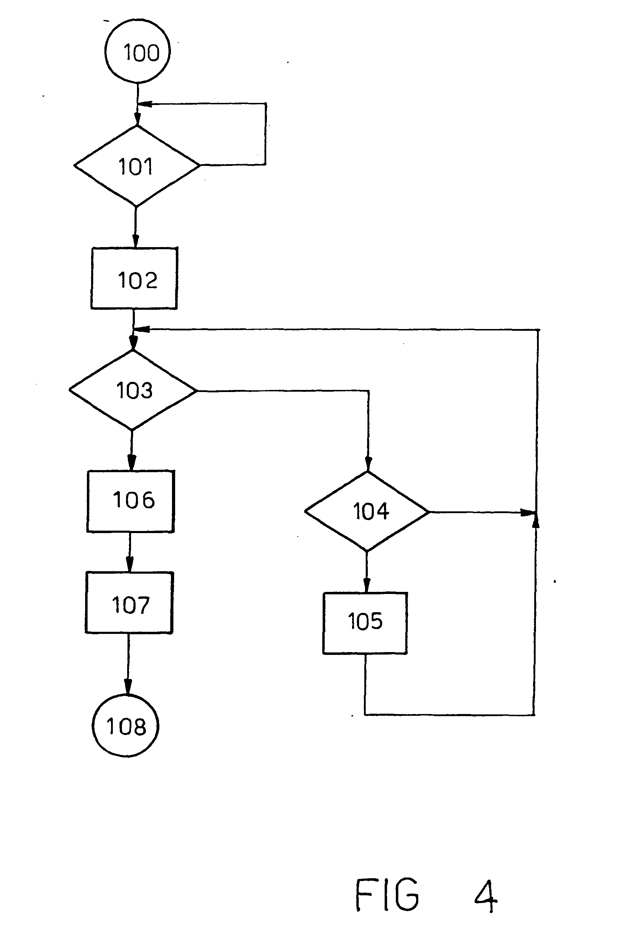

In figure 4 a block diagram of a part of the logic control circuit of the apparatus in figure 1 is represented; such a circuit, that can be incorporated in the block indicated in figure 1 with the number 17, can be indifferently made with the system of cabled logic or with a system of logic programming, i.e. utilising a microprocessor; such second system is generally less expensive, also because normally televisions and video recorders contain one or more microprocessors; the part represented in figure 4 is typical of the invention.

Block 100 is the starting block of the operations for the selection of the program.

Block 101 is a control block, it checks whether key W has been depressed; in an affirmative case control passes to block 102, in a negative case control back to the same block 101 (in all control blocks the lower exit is the YES exit whereas the side exit is the NO exit).

Block 102 shows the multiple page (icon map), in which every image corresponds to one of the 16 programs memorised by the user, with the known proceeding, in the programs memory; the numbers P are also generated, by means of a suitable character generator, and the cursor F, that is placed on the image N° 1, and is in the box on the top left hand corner of the screen. Control then passes to block 103.

Block 103 os a control block; it checks whether key E has been pressed; in an affirmative case, control passes to block 106; in a negative case, control passes back to block 104.

Block 104 is a control block; it controls whether one of the keys K has been depressed; in an affirmative case control passes to block 105; in a negative case the control passes back to block 103.

Block 105 cancels the cursor from the box in which it is to be found and makes it visible in the adjacent box depending on the particular key K depressed; then control passes back to block 103.

Block 106 identifies the box in which the marker is to be found, interrogating the state of the character generator, and calculating from the line and column number; then passing control to the successive block 107.

Block 107 supplies the appropriate operative commands to read the memory of the co-ordinate of the tuning of the corresponding program of the selected icon; to provide such a co-ordinate to tuner 7; and finally to show on all the screen the image corresponding to the television signal tuned by the tuner. Control then passes to block 108.

Block 108 is the final operations block for the selecting of the program.

The characteristics of the described apparatus result clearer from the present description and annexed drawings.The enclosed description also explains the advantages of the apparatus of said invention.

In particular they consist in the fact that it is possible for the user to select in easy and intuitive way the program that he wants to watch, moving the cursor to the corresponding icon by means of eight special keys, using at most three movements of the cursor, in the case described of 16 programs; and therefore by depressing the special key E the display on the full screen of the selected program is obtained.

It is also clear that numerous variants can be supplied by the skilled man to the display apparatus of television images described as an example, without however departing from the scope of the invention as defined by the claims.

For example, rather than a key device,to move the marker, a device containing a sphere could be used, to move the same marker in the direction in which the same sphere is rotated; devices of this kind are already known.

## Claims

1. Device for selecting the tuning of television signals, comprising means (7) for tuning television signals, a memory means for memorising tuning information, relative to preferred signals, and an image display means (S) having the possibility to visualise information to facilitate the tuning of said preferred signals, said information being represented by an image comprising a multiplicity of pictures, **characterised in that** said pictures are graphic pictures (I) each one of them representing the logotype that is normally used by the corresponding broadcasting station to identify itself, said graphic pictures (I) being memorised in a nonvolatile memory (19) contained in said device, and the selection of the television signal being effected by means which selects by marking on the image display means the relevant graphic picture (I) and consequently sending from said memory means tuning information corresponding to the selected graphic picture (I) to the tuning means (7), and that means are provided to move a cursor onto the chosen graphic symbol and that said means are also provided with a plurality of usual keys which serve for the control of the normal functions of said device and that said means for moving the cursor and the plurality of usual keys are provided on a remote control unit or on a control panel of said device, and that said remote control is also provided with "+" and "-" keys that are normally provided on every remote control unit, said "+" and "-" keys being used to pass from one displayed image to the next.

2. Device for the selection of television signals, according to claim 1, **characterised in that** the selection of said signals can be made by moving a special cursor ( F ) onto the graphic symbol corresponding to the desired program and therefore activating a command means (E).

3. Device for the selection of television signals, according to claim 1, **characterized in that** said means (K) for moving the marker (F) are also provided for diagonal movements.

4. Device for the selection of television signals, according to claim 3, **characterized in that** said means (K) for moving the cursor (F) also in a diagonal sense include a command device (R) with eight keys (K) disposed according to the vertexes of an octagon.

5. Device for the selection of television signals, according to claim 4, **characterized in that** said eight keys (K) are in the form of isosceles triangles, with the vertex directed externally.

6. Device for the selection of television signals, according to claim 3, **characterized in that** said means (K) for moving the marker (F), also in a diagonal sense, include a command device (R) with a single key in the form of an octagon.

7. Device for the selection of television signals, according to claim 3, **characterized in that** said means (K) for moving the marker (F), also in a diagonal sense, include a command device (R) with a single key in the form of a disc.

8. Device for the selection of television signals, according to claim 3, **characterized in that** said means (K) for moving the marker (F), also in a diagonal sense, include a command device with a sphere.

9. Device for the selection of television signals, according to one or more of the previous claims, **characterized in that** said cursor is composed of a luminous element (F) that appears on the screen (S).

10. Device for the selection of television signals, according to claim 9, **characterized in that** said cursor (F) flashes.

11. Device for the selection of television signals, according to claim 9, **characterized in that** said cursor (F) is in the form of an arrow.

12. Device for the selection of television signals, according to claim 9, **characterized in that** said cursor is represented by a number (11) made to flash.

13. Device for the selection of television signals, according to claim 2, **characterized in that** said command means, that enable the visualisation on the full screen of the selected program, include a key (E).

14. Device for the selection of television signals, according to claim 13, **characterized in that** said key (E) generates a command signal for selecting the program corresponding to the number (N) of the marked image (11) obtained based on the co-ordinate (line-column) on which the character generator, that generates such number (N), writes it on the image (11).

15. Device for the selection of television signals, according to claim 1, **characterized in that** an entrance of signals (IT) has been pre-arranged for memorising in said memory (19) other graphic symbols (1).

16. Device for the selection of television signals, according to claim 1, **characterized in that** the possibility has been provided for the direct acquisition of said graphic symbols (1) from a teletext page coupled to the tuned television signal, and memorise them in said memory (19), by means of a special circuit (17) pre-arranged in case of need.

17. Device for the selection of television signals, according to claim 16 **characterized in that** said acquisition from a teletext page is carried out by said circuit (17) automatically, as soon as the relative television signal is tuned.

18. Device for the selection of television signals, according to claim 2, **characterized in that** said command means include a transmitter (S) of a remote control unit.

## Patentansprüche

1. Vorrichtung zum Auswählen der Abstimmung von Fernsehsignalen, mit einer Einrichtung (7) zum Abstimmen von Fernsehsignalen, einer Speichereinrichtung zum Speichern der Abstimm-Information, welche zu den bevorzugten Signalen gehört, und einer Bildanzeigeeinrichtung (S) mit der Möglichkeit, Information zu visualisieren, um die Abstimmung der bevorzugten Signale zu unterstützen, wobei die Information durch ein Bild mit mehreren Abbildungen dargestellt wird,
**dadurch gekennzeichnet, daß** die Abbildungen graphische Abbildungen (I) sind, von denen jede das Logo darstellt, welches von der entsprechenden Rundfunkstation normalerweise verwendet wird, um sich selbst zu identifizieren, wobei die graphischen Abbildungen (I) in einem nichtflüchtigen Speicher (19) gespeichert werden, welcher in der Vorrichtung enthalten ist, und daß die Selektion des Fernsehsignals bewirkt wird durch eine Einrichtung, welche durch Markieren auf der Bildanzeigeeinrichtung der relevanten graphischen Abbildung (I) und anschließendes Senden von Abstimm-Informationen aus der Speichereinrichtung entsprechend der ausgewählten graphischen Abbildung (I) zu der Abstimmeinrichtung (7) selektiert, und
daß Mittel zum Bewegen eines Cursors auf das gewählte graphische Symbol vorgesehen sind und daß die Mittel auch mit einer Vielzahl von üblichen Tasten ausgestattet sind, die zur Kontrolle der normalen Funktionen der Vorrichtung dienen und daß die Mittel zum Bewegen des Cursors und die Vielzahl der üblichen Tasten auf einer Fernbedienung oder auf einem Bedienfeld der Vorrichtung vorgesehen sind, und daß die Fernbedienung auch mit "+" und "-" Tasten ausgestattet ist, die normalerweise auf jeder Fernbedieneinheit vorgesehen sind, wobei die "+" und "-" Tasten benutzt werden, von einem angezeigten Bild zum nächsten zu gelangen.

2. Vorrichtung für die Auswahl von Fernsehsignalen nach Anspruch 1,
**dadurch gekennzeichnet, daß** die Selektion der Signale durch Bewegen eines besonderen Cursors (F) auf das dem gewünschten Programm entsprechende graphische Symbol und entsprechendes Aktivieren einer Befehlseinrichtung (E) ausgeführt werden kann.

3. Vorrichtung für die Auswahl von Fernsehsignalen nach Anspruch 1,
**dadurch gekennzeichnet, daß** die Einrichtung (K) zum Bewegen des Cursors (F) ebenfalls für diagonale Bewegungen vorgesehen ist.

4. Vorrichtung für die Auswahl von Fernsehsignalen nach Anspruch 3,
**dadurch gekennzeichnet, daß** die Einrichtung (K) zum Bewegen des Cursors (F) auch in einer diagonalen Richtung eine Befehlsvorrichtung (R) mit acht Tasten (K) beinhaltet, die entsprechend den Spitzen eines Oktagons angeordnet sind.

5. Vorrichtung für die Auswahl von Fernsehsignalen nach Anspruch 4,
**dadurch gekennzeichnet, daß** die acht Tasten (K) in der Form gleichschenkliger Dreiecke mit nach außen gerichteten Spitzen vorgesehen sind.

6. Vorrichtung für die Auswahl von Fernsehsignalen nach Anspruch 3,
**dadurch gekennzeichnet, daß** die Einrichtung (K) zum Bewegen des Cursors (F) auch in einer diagonalen Richtung eine Befehlsvorrichtung (R) mit einer einzelnen Taste in der Form eines Oktagons beinhaltet.

7. Vorrichtung für die Auswahl von Fernsehsignalen nach Anspruch 3,
**dadurch gekennzeichnet, daß** die Einrichtung (K) zum Bewegen des Cursors (F) auch in einer diagonalen Richtung eine Befehlsvorrichtung (R) mit einer einzelnen Taste in der Form einer Platte beinhaltet.

8. Vorrichtung für die Auswahl von Fernsehsignalen nach Anspruch 3,
**dadurch gekennzeichnet, daß** die Einrichtung (K) zum Bewegen des Cursors (F) auch in einer diagonalen Richtung eine Befehlsvorrichtung mit einer Kugel beinhaltet.

9. Vorrichtung für die Auswahl von Fernsehsignalen nach einem oder mehreren der vorstehenden Ansprüche,
**dadurch gekennzeichnet, daß** der Cursor aus einem leuchtenden Element (F) gebildet ist, das auf dem Bildschirm (S) erscheint.

10. Vorrichtung für die Auswahl von Fernsehsignalen nach Anspruch 9,
**dadurch gekennzeichnet, daß** der Cursor (F) blinkt.

11. Vorrichtung für die Auswahl von Fernsehsignalen nach Anspruch 9,
**dadurch gekennzeichnet, daß** der Cursor (F) die Form eines Pfeils aufweist.

12. Vorrichtung für die Auswahl von Fernsehsignalen nach Anspruch 9,
**dadurch gekennzeichnet, daß** der Cursor durch eine blinkende Nummer (11) dargestellt ist.

13. Vorrichtung für die Auswahl von Fernsehsignalen nach Anspruch 2,
**dadurch gekennzeichnet, daß** die Befehlseinrichtung, welche die Darstellung des ausgewählten Programms auf dem gesamten Bildschirm ermöglicht, eine Taste (E) beinhaltet.

14. Vorrichtung für die Auswahl von Fernsehsignalen nach Anspruch 13,
**dadurch gekennzeichnet, daß** die Taste (E) ein Befehlssignal zum Auswählen des Programms entsprechend der Nummer (N) des markierten Bildes (11) erzeugt, die basierend auf den Koordinaten (Zeile-Spalte) erhalten wird, welche der Zeichengenerator, der diese Nummer (N) erzeugt, auf dem Bild (11) schreibt.

15. Vorrichtung für die Auswahl von Fernsehsignalen nach Anspruch 1,
**dadurch gekennzeichnet, daß** ein Eintrag von Signalen (IT) zum Speichern anderer graphischer Symbole (1) in dem Speicher (19) vorab angeordnet wurde.

16. Vorrichtung für die Auswahl von Fernsehsignalen nach Anspruch 1,
**dadurch gekennzeichnet, daß** die Möglichkeit zur direkten Erfassung der graphischen Symbole (1) von einer Teletext-Seite, welche an das abgestimmte Fernsehsignal gekoppelt ist, vorgesehen wurde, und Speichern dieser in dem Speicher (19) durch eine Einrichtung einer besonderen Schaltung (17), die bei Bedarf vorab angeordnet ist.

17. Vorrichtung für die Auswahl von Fernsehsignalen nach Anspruch 16,
**dadurch gekennzeichnet, daß** die Erfassung von einer Teletext-Seite durch die Schaltung (17) automatisch ausgeführt wird, sobald das zugehörige Fernsehsignale abgestimmt ist.

18. Vorrichtung für die Auswahl von Fernsehsignalen nach Anspruch 2,
**dadurch gekennzeichnet, daß** die Befehlseinrichtung einen Sender (S) einer Fernsteuerung beinhaltet.

## Revendications

1. Dispositif permettant de sélectionner le réglage de signaux de télévision, comprenant des moyens (7) pour régler les signaux de télévision, des moyens de mémoire pour mémoriser des informations de réglage, relatives aux signaux préférés et des moyens d'affichage d'image (S) présentant la possibilité de visualiser les informations afin de faciliter le réglage desdits signaux préférés, lesdites informations étant représentées par une image comprenant une multitude de représentations, **caractérisé en ce que** lesdites représentations sont des représentations graphiques, chacune d'elles représentant le logo qui est normalement utilisé par la station de diffusion correspondante afin de l'identifier, lesdites représentations graphiques (I) étant mémorisées dans une mémoire non volatile (19) contenue dans ledit dispositif et la sélection du signal de télévision étant effectuée par des moyens qui sélectionnent en marquant sur les moyens d'affichage d'image la représentation graphique appropriée (I) et par conséquent en transmettant aux moyens de réglage (7) depuis lesdits moyens de mémoire, les informations de réglage correspondant à la représentation graphique choisie (I), et **en ce que** des moyens sont prévus pour déplacer un curseur sur le symbole graphique choisi et **en ce que** lesdits moyens sont également prévus avec une pluralité de touches courantes, lesquelles servent à contrôler les fonctions habituelles dudit dispositif et **en ce que** lesdits moyens pour déplacer le curseur et la pluralité de touches courantes sont prévus sur une télécommande ou sur un panneau de contrôle dudit dispositif, et que ladite télécommande est également prévue avec des touches « + » et « - » qui sont habituellement prévues sur toute télécommande, lesdites touches « + » et « - » étant utilisées pour passer d'une image affichée à une autre.

2. Dispositif pour la sélection de signaux de télévision selon la revendication 1, **caractérisé en ce que** la sélection desdits signaux peut être réalisée en déplaçant un curseur spécial (F) sur le symbole graphique correspondant au programme désiré et par conséquent en activant des moyens de commande (E).

3. Dispositif pour la sélection de signaux de télévision selon la revendication 1, **caractérisé en ce que** lesdits moyens (K) permettant de déplacer le marqueur (F) permettent également d'effectuer des mouvements en diagonale.

4. Dispositif pour la sélection de signaux de télévision selon la revendication 3, **caractérisé en ce que** lesdits moyens (K) permettant de déplacer le curseur (F), également dans une direction en diagonale, comprennent un dispositif de commande (R) muni de huit touches (K) disposées aux sommets d'un octogone.

5. Dispositif pour la sélection de signaux de télévision selon la revendication 4, **caractérisé en ce que** lesdites huit touches (K) sont sous la forme de triangles isocèles, le sommet étant dirigé vers l'extérieur.

6. Dispositif pour la sélection de signaux de télévision selon la revendication 3, **caractérisé en ce que** lesdits moyens (K) permettant de déplacer le marqueur (F), également dans une direction en diagonale, comprennent un dispositif de commande (R) muni d'une seule touche en forme d'octogone.

7. Dispositif pour la sélection de signaux de télévision selon la revendication 3, **caractérisé en ce que** lesdits moyens (K) permettant de déplacer le marqueur (F), également dans une direction en diagonale, comprennent un dispositif de commande (R) muni d'une seule touche en forme de disque.

8. Dispositif pour la sélection de signaux de télévision selon la revendication 3, **caractérisé en ce que** lesdits moyens (K) permettant de déplacer le marqueur (F), également dans une direction en diagonale, comprennent un dispositif de commande muni d'une sphère.

9. Dispositif pour la sélection de signaux de télévision selon une ou plusieurs des revendications précédentes, **caractérisé en ce que** ledit curseur se compose d'un élément lumineux (F) qui apparaît sur l'écran (S).

10. Dispositif pour la sélection de signaux de télévision selon la revendication 9, **caractérisé en ce que** ledit curseur (F) clignote.

11. Dispositif pour la sélection de signaux de télévision selon la revendication 9, **caractérisé en ce que** ledit curseur (F) est en forme de flèche.

12. Dispositif pour la sélection de signaux de télévision selon la revendication 9, **caractérisé en ce que** ledit curseur est représenté par un numéro (11) qui clignote.

13. Dispositif pour la sélection de signaux de télévision selon la revendication 2, **caractérisé en ce que** lesdits moyens de commande qui permettent la visualisation sur plein écran du programme choisi comprennent une touche (E).

14. Dispositif pour la sélection de signaux de télévision selon la revendication 13, **caractérisé en ce que** ladite touche (E) produit un signal de commande permettant de sélectionner le programme correspondant au numéro (N) de la représentation marquée (11) obtenu à partir des coordonnées (ligne/colonne) sur lesquelles se base le générateur de caractères qui produit ledit numéro (N) pour l'inscrire sur la représentation (11).

15. Dispositif pour la sélection de signaux de télévision selon la revendication 1, **caractérisé en ce qu'**une entrée de signaux (IT) a été agencée au préalable afin de mémoriser dans ladite mémoire (19) d'autres symboles graphiques (1).

16. Dispositif pour la sélection de signaux de télévision selon la revendication 1, **caractérisé en ce qu'**il a été offert la possibilité d'effectuer l'acquisition directe desdits symboles graphiques (1) à partir d'une page de télétexte couplée au signal de télévision réglé et de les mémoriser dans ladite mémoire (19) au moyen d'un circuit spécial (17) agencé au préalable en cas de besoin.

17. Dispositif pour la sélection de signaux de télévision selon la revendication 16, **caractérisé en ce que** ladite acquisition provenant d'une page de télétexte est réalisée automatiquement par ledit circuit (17) dès que le signal de télévision relatif est réglé.

18. Dispositif pour la sélection de signaux de télévision selon la revendication 2, **caractérisé en ce que** lesdits moyens de commande comprennent un émetteur (S) de télécommande.
